Europäisches Patentamt

European Patent Office

Office européen des brevets

(11) Veröffentlichungsnummer: **0 508 480 A1**

## (12) EUROPÄISCHE PATENTANMELDUNG

(21) Anmeldenummer: **92106296.4**

(22) Anmeldetag: **11.04.92**

(51) Int. Cl.5: **H03F 3/50**, H03F 3/30

(30) Priorität: **12.04.91 DE 4111999**

(43) Veröffentlichungstag der Anmeldung:
**14.10.92 Patentblatt 92/42**

(84) Benannte Vertragsstaaten:
**PT**

(71) Anmelder: **TELEFUNKEN Fernseh und Rundfunk GmbH**
**Göttinger Chaussee 76**
**W-3000 Hannover 91(DE)**

(72) Erfinder: **Köllner, Hartmut**
**Asternstrasse 47**
**W-3000 Hannover 1(DE)**

(54) **Wandlerschaltung.**

(57) Bei einer Wandlerschaltung bestehend aus einem ersten Transistor (T11) dessen Basis eine Eingangssignal zuführbar ist, einem zweiten, zum ersten Transistor (T11) komplementären Transistor (T12) dessen Basis mit dem Emitter des ersten Transistors (T11) verbunden ist und dessen Emitter über einen ersten Widerstand (R1) mit einer Ausgangsklemme (B) verbunden ist, und mit einer Stromzuführunsschaltung (T13, T14) die den Stromfluß durch die Stromzuführungsschaltung (T13, T14) die den Stromfluß durch die Emitter-Kollektor-Strecken der beiden Transistoren (T11, T12) steuert läßt sich ein Ausgangswiderstand von praktisch 0 durch eine mit dem Emitter des ersten Transistors (T11) verbundenen zweiten Widerstand (R2), der vom Kollektor-Emitter-Strom des ersten Transistors (T11) mit der Basis des zweiten Transistors(T12) verbunden ist erreichen.

Besonders vorteilhaft ist es, wenn die Transistoren des Stromspiegels die gleiche Polarität aufweisen, wie der in den jeweils zugeordnete, vom gleichen Strom durchflossene erste bzw. zweite Transistor (T11; T12).

Fig. 3

Die Erfindung betrifft eine Wandlerschaltung, bestehend aus einem ersten Transistor dessen Basis ein Eingangssignal zuführbar ist, einem zweiten, zum ersten Transistor komplementären Transistor, dessen Basis mit dem Emitter des ersten Transistors verbunden ist und dessen Emitter über einen ersten Widerstand mit einer Ausgangsklemme verbunden ist und mit einer Stromzuführungsschaltung, die einen im wesentlichen gleichen Stromfluß durch die Emitter-Kollektor-Strecken sicherstellt.

Eine derartige Wandlerschaltung ist durch die DE 30 35 471 C2 bekannt. Die dort in Figur 3 dargestellte Schaltung besteht somit aus zwei kaskadenförmig zusammengeschalteten Emitterfolgern. Aufgrund der positiven Temperaturkoeffizienten des verwendeten Bipolartransistors muß der Ruhestrom in komplemetären Stufen durch den eine Stromgegenkopplung bildenden ersten Widerstand stabilisiert werden. Hierdurch kommt es zu einem ausgangsstromabhängigen Spannungsabfall an dem Gegenkopplungswiderstand, was zu einer Spannungsaussteuerungsminderung führt, da der Steuerspannungshub größer als der Ausgangsspannungshub ist. Damit hat der Emitterfolger dieser Konfiguration nicht die geforderten Eigenschaften eines idealen Impedanzwandlers, nämlich einen sehr geringen Ausgangswiderstand, der gegen Null geht. In einer bekannten Schaltungstechnik wird der Nachteil des begrenzt niedrigen Ausgangswiderstandes häufig durch starke Gegenkoppelung über alle Stufen (Spannungs- und Stromverstärkerstufen) des Wandlers kompensiert.

Es ist ferner versucht worden, die negative Wirkung des Stromgegenkopplungswiderstandes an diesem selbst zu mindern, z. B. durch Überbrücken des Widerstandes mit Dioden, durch Stromentlastungsschaltungen oder Quad-Brückenschaltungen. Alle diese Schaltungen benötigen aber regelmäßig aufwendige Ruhestromstabilisierungen, selektierte Transistoren und (bei der Quad-Schaltung) ein aufwendig zu dimensionierendes Schaltungskonzept. Die Diodenübertragung wirkt erst ab einer Spannung von 0,6 V, der Ruhestrom muß unter 0,6 V liegen, so daß die Ruhestromeinstellung nicht frei wählbar ist. Für Komplementärverstärker kommt es im A- bzw. AB-Betrieb zu Übernahmeverzerrungen. Die Stromentlastungsschaltungen gestatten nur mit einem relativ großen Aufwand eine Näherung an den Ausgangswiderstand Null.

Das eingangs erwähnte Schaltungskonzept hat den Vorteil, daß die zueinander inversen Emitterfolger, die mit im wesentlichen gleichen Strömen durchflossen werden eine Kompensation der nicht linearen Kennlinien der Transistoren bewirken. Das bekannte Schaltungskonzept wird regelmäßig für nichtverzerrende Verstärker eingesetzt, erlaubt jedoch keine Ausbildung als dem Ideal angenäherter Impedanzwandler.

Der Erfindung liegt die Aufgabe zugrunde, eine Wandlerschaltung der eingangs erwähnten Art so auszubilden, daß ein Ausgangswiderstand von praktisch Null erreichbar ist,und die Steuerkennlinienverzerrungen vollständig kompensiert sind.

Diese Aufgabe wird erfindungsgemäß bei einer Wandlerschaltung der eingangs erwähnten Art gelöst durch einen mit dem Emitter des ersten Transistors verbundenen zweiten Widerstand, der vom Kollektor-Emitter-Strom des ersten Transisitors durchflossen ist und über den der Emitter des ersten Transistors mit der Basis des zweiten Transistors verbunden ist.

Durch die Einfügung des erfindungsgemäßen Widerstandes in die Verbindung zwischen dem Emitter des ersten Transistors und der Basis des zweiten Transistors so, daß durch den zweiten Widerstand der Emitter-Kollektor-Strom des ersten Transistors hindurchfließt, bewirkt eine automatische Kompensation des Spannungsabfalls über dem als Stromgegenkopplungswiderstand wirkenden ersten Widerstand, in dem die Spannung an der Basis des zweiten Transistors durch den Spannungsabfall über dem ersten Widerstand exakt kompensiert werden, wenn die beiden Widerstände gleich groß sind. Durch eine geeignete Dimensionierung des zweiten Widerstandes relativ zu dem ersten Widerstand können aber auch beliebige positive oder negative Ausgangswiderstände des Wandlers eingestellt werden. Selbstverständlich müssen bei einem negativen Ausgangswiderstand Sicherheitsmaßnahmen vorgesehen werden.

Durch die unterschiedliche Polarität des Eingang- und Ausgangstransistors und den damit verbundenen unterschiedlichen Arbeitspunkten bei gleichen Strömen ist die Kompensation begrenzt. Um zwischen den Eingangs- und Ausgangstransistoren bei gleichen Strömen eine vollständige Kennliniensymmetrie zu schaffen werden beiden jeweils ein komplementärer als Diode geschalteter Transistor in Serie als Kompensationswiderstand hinzugefügt. Beide Kennlinien (Transistor und Diode) ergeben zusammengefügt eine neue, für beide Seiten gleiche Steuerkennlinie, die vollständig kompensierbar ist. Die Stromzuführungsschaltung beinhaltet vorzugsweise einen an sich bekannten Stromspiegel mit zwei mit ihren Basen miteinander verbundenen Transistoren.

Eine besonders vorteilhafte Ausführungsform der erfindungsgemäßen Schaltung läßt sich dadurch realisieren, daß die beiden Transistoren des Stromspiegels eine unterschiedliche Polarität aufweisen, so daß sie die gleiche Polarität aufweisen wie der ihnen jeweils zugeordnete, vom gleichen Strom durchflossene erste bzw. zweite Transistor In diesem Fall ist es nämlich möglich, die beiden jeweils vom gleichen Strom durchflossenen Transistoren als identische Doppeltransistoren vor einem gemeinsamen Substrat auszubilden, wodurch gleiche Eigenschaften und gleiche Kennlinien der beiden Transistoren sichergestellt sind.

Dabei kann es zweckmäßig sein, wenn der erste Transistor zusammen mit dem zweiten Widerstand und dem zugehörigen Transistor des Stromspiegels eine Konfiguration mit zwei gleichpoligen Transistoren und einem zwischengeschalteten Widerstand bildet, die invers am zweiten Transistor zusammen mit einem zwischengeschaltetem Widerstand und dem zugehörigen Transistor des Stromspiegels realisiert ist. Auf diese Weise läßt sich das erfindungsgemäße Schaltungskonzept mit zwei Doppeltransistoren ausbilden.

Die erfindungsgemäße Wandlerschaltung kann als eine komplementäre Wandlerschaltung ausgebildet sein, wodurch sich die Bauteile spiegelbildlich und invers verdoppeln. In dieser Ausführungsform können vier gleiche Konfigurationen hintereinander geschaltete Brückenzweige bilden. Eine völlige Symmetrie in völlig gleicher Ausbildung in jedem Brückenzweig läßt sich dadurch erreichen, daß in jedem Brückenzweig jeweils ein Widerstand hinzugeschaltet ist, dessen Wert dem ersten Widerstand entspricht. In die Brückenschaltung ist dann auch der als Gegenkopplungswiderstand wirkende erste Widerstand integriert.

Die Arbeitspunkteinstellung des Wandlers ist durch eine Vorspannungsquelle wählbar, die mit der Basis des zweiten Transistors verbunden ist. Bei der komplementären Ausbildung der Wandlerschaltung ist die Vorspannungsquelle zwischen den Basen zueinander inversen zweiten Transistoren angeordnet.

Die Vorspannungsquelle kann aber auch in Form eines linearen Widerstandes oder eines spannungsabhängigen Widerstandes in einem ruhestrombegrenzenden Nebenpfad der Schaltung liegen. In diesem Fall läßt sich der Ruhestrom über die ,in einem weiteren Nebenpfad der Schaltung liegenden, Stomquellen einstellen.

Die erfindungsgemäße Schaltung erlaubt eine interne, frei wählbare Ruhestromeinstellung, ohne die Symmetrie der Schaltung zu stören.

Die erfindungsgemäße Schaltungstechnik erlaubt die Realisierung von universellen Bauteilen mit idealen Eigenschaften. Insbesondere ist die Realisierung von idealen Transistorstrukturen möglich, wobei die vertikale Symmetrie in den mit den ersten und dem zweiten Transistor gebildeten Stromzweigen von entscheidender Bedeutung ist.

Die Erfindung soll im folgenden anhand von in der Zeichnung dargestellten Ausführungsbeispielen näher erläutert werden. Es zeigen:

Figur 1: eine komplementäre Impedanzwandlerschaltung

Figur 2A: eine schematische Darstellung des prinzipiellen Aufbaus einer Impedanzwandlerschaltung mit einem Stromspiegel aus zwei gleichen Transistoren (horizontale Symmetrie)

Figur 2B: eine Variante mit zusätzlichen komplementären Transistordioden unter Ausbildung einer horizontalen Symmetrie

Figur 3: eine Variante der Schaltung gemäß Figur 2 A und B mit einer Stromzuführungsschaltung mit komplementären Transistoren unter Ausbildung einer vertikalen Symmetrie

Figur 4: eine schematische Darstellung der Schaltung gemäß Figur 3 mit paarweise auf einem gemeinsamen Substrat aufgebauten Transistoren

Figur 5A: einen nach dem Prinzip der Figuren 3 und 4 aufgebauten komplementären Impedanzwandler mit einer Stromentlastung und einem schaltungsintenen Ruhestromnebenpfad.

Figur 5B: einen nach dem Prinzip der Figuren 3 und 4 aufgebauten komplementären Impedanzwandler mit doppelsymmetrischer Ruhestromeinspeisung

Figur 5C: einen nach dem Prinzip der Figur 2B aufgebauten komplementären Impedanzwandler mit gleichen, aber unlinearen Widerständen und einer aktiven Transistorvorspannungsquelle im strombegrenzenden Nebenpfad

Figur 5D: einen nach dem Prinzip der Figur 3 und 4 aufgebauten komplementären Impedanzwandler mit aktiver Vorspannungsquelle

Figur 6: ein in der Schaltungstechnik der Figuren 3 und 4 aufgebautes universelles Transistorbauteil

Figur 7A: ein Bauteil mit lateralem pnp-Transistor

Figur 7B: ein Bauteil mit Darlingtonausgangskreis

Figur 7C: ein Bauteil gemäß Figur 6 in Hybrid-Technik

Figur 7D: ein Bauteil gemäß Figur 6 in MOSFET-Technik ohne zusätzliche Widerstände im Ausgangskreis

Figur 8A: einen integrierten Leistungsdarlingtontransistor

Figur 8B: einen diskreten Aufbau von Steuerstufe und Stromentlastung

Figur 8C: einen kompensierten Source- Folger

Figur 8D: einen stromentlasteten Source-Folger

Figur 9: ein pnp-Transistorbauteil

Figur 10: ein npn-Transistorbauteil

Figur 11: ein universell einsetzbarer integrierter Schaltkreis

Figur 12: ein Dual-Schaltkreis in komplementärer Technik

Figur 13: ein Transistorbauteil mit einer Stromentlastungsschaltung

Figur 14: eine gegenüber Figur 13 modifizierte Schaltung mit gleicher Wirkung

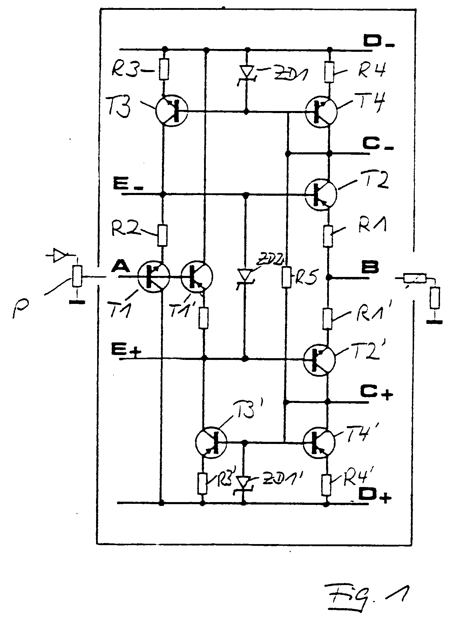

Bei dem in Figur 1 dargestellten Ausführungsbeispiel ist eine Eingangssignalklemme A mit einem Abgriff eines des Eingangssignals zuführenden Po-tentiometers P verbunden. Mit der Eingangssignalklemme A ist die Basis eines ersten bipolaren Transistors T1, der als npn-Transistor ausgebildet ist, und die Basis eines inversen (pnp) Transistors T1'verbunden. Der Emitter des Transistors T1 ist mit der Basis eines zweiten Transistors T2 verbunden, der (ebenfalls) als Emitterfolger geschaltet ist und dessen Emitter über einen ersten Widerstand R1 mit einer Ausgangsklemme B verbunden ist. In die Verbindung zwischen dem Emitter des ersten Transistors T1 und der Basis des zweiten Transitors T2 ist ein zweiter Widerstand eingeschaltet.

Die Stromzufuhr zu den beiden Transistoren T1 und T2 erfolgt über einen Stromspiegel, der aus zwei mit ihren Basen miteinander verbundenen Transistoren T3 und T4 besteht. Deren Emitter sind jeweils über einen Emitter-Widerstand R3 bzw. R4 mit einer negativen Versorgungsspannung D- verbunden. Der dem zweiten Transistor T2 zugeordnete Transistor T4 des Stromspiegels ist als Diode geschaltet, weist also eine direkte Verbindung zwischen seinem Kollektor und seiner Basis auf. Dieser an sich bekannte Stromspiegel bewirkt, daß durch die beiden Transistoren T1 und T2 gleiche Ströme fließen. Der Kollektor des ersten Transistors T1 ist dabei mit einer positiven Versorgungsspannung D+ verbunden. Die an dem ersten Widerstand R1 abfallende, mit dem übertragenen Signal variierende Spannung wird in genau der gleichen Größe dam Ausgangssignal hinzuaddiert, wenn der zweite Widerstand R2 gleich groß wie der erste Widerstand R1 gewählt ist. Da durch die beiden Widerstände R1, R2 gleiche Ströme fließen, fallen über sie gleiche Spannungen ab. Die Eingangssignalspannung, die am Emitter des ersten Transistors T1 ansteht, würde ohne den zweiten Widerstand R2 um die am ersten Widerstand R1 abfallende Spannung reduziert werden. Durch die Spannungserhöhung am Widerstand R2 wird die Signalspannung um die am Widerstand R1 abfallende Spannung erhöht, so daß die Spannung E- an der Basis des zweiten Transistors T2 der negativen Signalspannung, erhöht durch den Spannungsabfall am Widerstand R2 (bzw.. R1) entspricht. Bei der erfindungsgemäßen Schaltungsanordnung kompensieren sich daher nicht nur die nichtlinearen Diodenwege der beiden Transistoren T1, T2 sondern auch die Spannungsabfälle an den Widerständen R1, R2 wenn diese gleich groß gewählt sind. Somit läßt sich ein Impedanzwandler mit einem Ausgangswiderstand Null realisieren. Wird der Widerstand R2 < R1 gewählt, verbleibt ein positiver Ausgangswiderstand, während der Ausgangswiderstand negativ wird, wenn R2>R1 gewählt wird.

Die in Figur 1 dargestellte Schaltungsanordnung ist eine komplementäre Anordnung. Die für die positive Signalspannung vorgesehene Schaltungshälfte entspricht der beschriebenen Schaltungshälfte für die negative Signalspannung und ist mit entsprechenden Bezugsziffern, ergänzt durch " '" gekennzeichnet.

Zwischen den Versorgungsspannungen D+ bzw. D- und den zugehörigen Basen der Transistoren T3, T4 der Stromspiegel sind jeweils Zehnerdioden ZD1, ZD1'angeordnet, die den maximalen Strom durch die Transistoren T1, T2 bzw. die Transitoren T3, T4 begrenzen, falls beispielsweise an der Ausgangsklemme ein Kurzschluß entstehen sollte.

Eine zwischen die Basen der beiden zweiten Transistoren T2 und T2'geschaltete Zehnerdiode ZD2 legte den Arbeitspunkt auf den Kennlinien der beiden Transistoren T2, T2' fest. Ein mit den Kollektoren der beiden Transistoren T4, T4'verbundener Widerstand R5 bildet einen Ruhestromnebenpfad und ermöglicht eine Ruhestrom beim Einschalten der Schaltung.

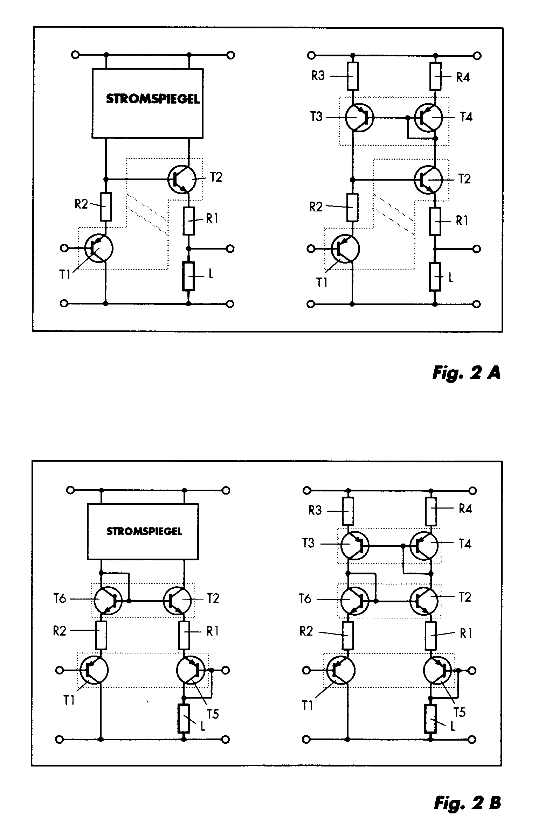

Figur 2A veranschaulicht die Prinzipschaltung, die in Figur 1 verwirklicht worden ist. Die beiden möglichst gleichen Transistoren T3, T4 bilden den Stromspiegel und sorgen für einen gleichgroßen Strom durch die Transistoren T1, T2, die komplementär zueinander ausgebildet sind.

Um für jeden Arbeitspunkt der Schaltung das gewünschte Ergebnis zu erzielen, müsen nicht nur die Kennlinien der Transitoren T3, T4 gleich sein sondern möglichst auch die Kennlinine der komplementären Transistoren T1, T2. Die Schaltung beruht somit auf einer horizontalen Symmetrie zwischen den Transistorpaaren T3, T4 und T1, T2. Die Einhaltung dieser Symmetriebedingung ist für die komplementären Transistoren T1, T2 nur angenähert möglich.

Figur 2B zeigt wie der Eingangs- und Ausgangstransistor durch jeweils einen komplementären Diodentransistor (T5,T6) ergänzt sind. Durch die Hintereinanderschaltung zweier unterschiedlicher Diodenstrecken ergibt sich bei horizontaler Symmetrie von Transistor und Diodentransistor auf beiden Seiten die gleiche Steuerkennlinie.Die Schaltung ist horizontal- Symmetrisch aufgebaut und erreicht bei hinreichend genauer Fertigung der Transistoren eine vollständige Kompensation der Steuerkennlinienverzerrungen.

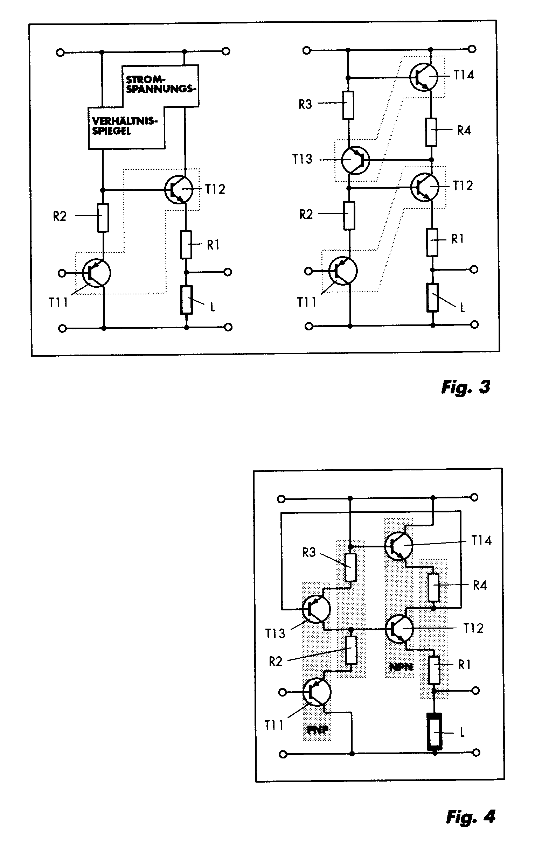

Figur 3 zeigt eine Variante der Schaltung gemäß Figur 2, die auf einem anderen Funktionsprinzip beruht. Transistoren T11 und T12 sind in der glechen Weise miteinander verschaltet wie die Transistoren T1 und T2 in der Schaltung gemäß Figur 2. In gleicher Weise wie der Transistor T3 in Figur 2 ist ein Transistor T13 in Serie mit der Kollektor-Emitter-Strecke des Transistors T11 angeordnet. Ein Transistor T14 ist hingegen in anderer Polarität als der Transistor T13 ausgebildet und mit seinem Emitter über den Widerstandt R4 mit dem Kollektor des Transistors T12 verbunden. Bei diesem Schaltungsaufbau ergibt sich eien vertikale Symmetrie, da die Transistoren T11 und T13 in gleicher Polarität, nämlich als pnp-Transistoren und die Transistoren T12 und T14 als npn-Transistoren ausgebildet sind. Figur 4 verdeutlicht, daß die pnp-Transistoren T11, T13 zweckmäßigerweise auf einem gemeinsamen Chip aufgebaut werden, so daß sie ein völlig gleiches Kennlinienverhalten zueinander aufweisen können. In gleicher Weise werden die npn-Transistoren T12,T14 auf einem gleichen Chip aufgebaut. Die Widerstände R1, R2, R3, R4 können paarweise ebenfalls gleich aufgebaut sein, so daß sich eine vollkommene vertikale Symmetrie ergibt. Das Funktionsprinzip dieser Schaltung beruht nun nicht mehr darauf, daß in den beiden Transistoren T1, T2 durch den Stromspiegel völlig gleiche Ströme hindurchfließen sondern darauf, daß durch die vertikale Symmetrie die Verschaltung nach Art einer Brücke erfolgt, in der gleiche Teilstreckenspannungen bestehen, so daß die an der Basis des Transistors T11 gegen Bezugspotential anstehende Eingangsspannung gleich der über einem Lastwiderstand L anstehende Ausgangsspannung ist. Dabei können in den beiden Stromzweigen T11, T13 bzs. T12, T14 durchaus unterschiedliche Ströme fließen, ohne die Kompensation der nichtlinearen Kennlinien der Transistoren T11 bis T14 zu stören. Dabei müssen die Widerstände R1 bis R4 entsprechend den unterschiedlichen Strömen dimensioniert sein. Die Schaltungen gemäß Figuren 3 und 4 verwenden somit komplementär aufgebaute "Stromspiegel" und beruhen auf einem vertikal symmetrischen Aufbau, bei dem die gleichen fehlerhaften npn-Transistoren auf der einen Seite durch zwei (im allgemeinen anders) fehlerbelastete, aber gleiche npn-Transistoren auf der anderen Seite genau kompensiert werden.

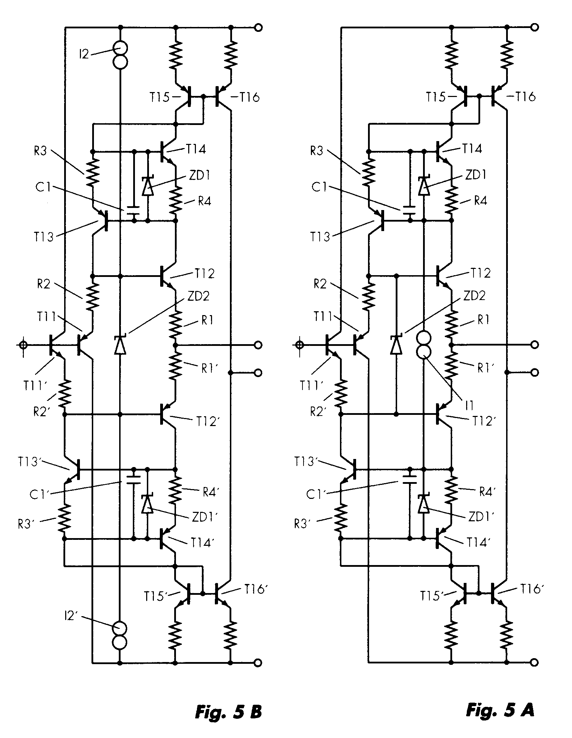

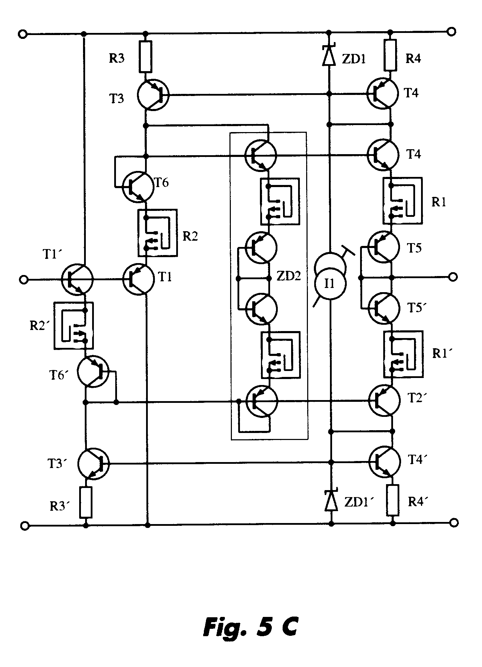

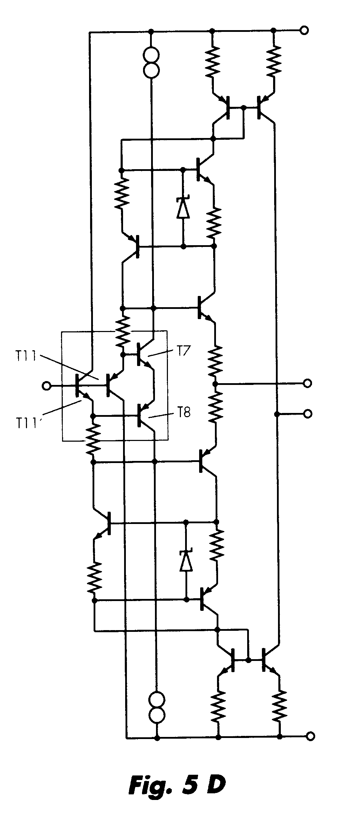

Figur 5A zeigt eine Schaltung, die wesentlich dem Schaltungsaufbau gemäß Figur 1 entspricht, wobei jedoch das Schaltungsprinzip gemäß den Figuren 3 und 4 realisiert ist. Durch jeweils eine der Zehnerdiode ZD1, ZD1' parallel geschaltete Kapazität C1, C1'wird eine frequenzabhängige Mitkopplungskompensation vorgenommen. Durch einen aus zwei Transistoren T15, T16 bzw. T15', T16'gebildeten Leistungsstromsppiegel kann der komplementäre Impedanzwandler vom Leistungsstrom entlastet werden und dient somit lediglich als Steuerschaltung. Die Stromquelle I1 in einem Nebenstrompfad der Schaltung sorgt dafür,daß erst einmal beim Einschalten der Versorgungsspannung (Ub) ein Ruhestrom in der Schaltung zustande kommt. Im eingeschalteten Zustand fließt der Strom der Stromquelle I1 Über die komplementären Stromspiegel (T13,T14;T13',T14') in die Vorspannungsquelle ZD2.

Figur 5B zeigt, wie eine zusätzliche Ruhestrombelastung der komplementären Stromspiegel ,die die vertikale Symmetrie stört, zu vermeiden ist. Die beiden gleich gewichteten Stromquelle( I2,I2') speisen den Stom direkt in die Vorspannungsquelle ZD2 ein.

Für die Vorspannungsquelle ZD2 ist auch ein weniger niederimpedantes Bauteil einsetzbar wie zum Beispiel ein einfacher Widerstand,da hier ein begrenzender Ruhestromgegenkopplungskreis besteht. Der Widerstand kann nur soviel Strom aufnehmen, wie über die Stromquellen ( I2oder I1) fremdeingespeist wird. Jeder weitere Spannungsanstieg über dem Widerstand ist mit einem Stromabzug aus der Schaltung verbunden,der sich in einer Herabsetzung der Mitkoppelungseffizienz der ganzen Schaltung äußert. Dieser Vorgang stabilisiert den Ruhesstrom.

Über die Stromquellen ist auch eine Offset-Trimmung möglich.

Figur 5C zeigt eine Schaltung, die gemäß Figur 2B realisiert wurde. Die linearen Widerstände sind durch Feldeffekttransistordioden ersetzt,die in ihrem Spannungs-Stromverhalten unlinear sind. Auf diese Weise werden spannungsabhängige Widerstände erzielt, die in ihren Kennlinien und dem damit verbundenen Innenwiderstand untereinander gleich sind. Die Symmetrie bleibt erhalten.

Der Grund für die Verwendung unlinearer Widerstände liegt in der unsymmetrischen Spannungs- und Stromverteilung zwischen dem oberen und unteren Teil der komplementären Schaltung .Bei einer Signalaussteuerung findet bei gleichen schaltungsinternen Spannungshüben im oberen und unteren Teil der Schaltung ein um einige Größenordnungen höherer Stromgewinn im (z. B.) oberen Teil der Schaltung statt,als dieser im unteren Teil an Stomminderung bewirkt. Die Schaltung arbeitet in einem dynamisch erweiterten Klasse- A Bereich und benötigt so für eine bestimme Ausgangsleistung einen geringeren Ruhestrom.

Die Vorspannungsquelle ZD 2 ist als Diodenstrecke im ruhestrombegrezenden Nebenpfad der Schaltung ausgeführt.

Figur 5D zeigt eine aktive, thermisch gekoppelte Transistorvorspannungsquelle (T7, T8) in einer Schaltung gemäß Figur 5B. Die Vorspannungstransistorquellen stellen einen hochsteilen spannungsgesteuerten Widerstand dar der durch die Spannung Über den beiden Basisanschlüssen der komplementären Transistoren gesteuert wird. Ein übermäßiger Ruhestrom- oder Stromanstieg wird auch entsprechend übermäßig über die Kollektorleitungen in einen Nebenpfad, eben der Vorspannungsquelle, abgeleitet.

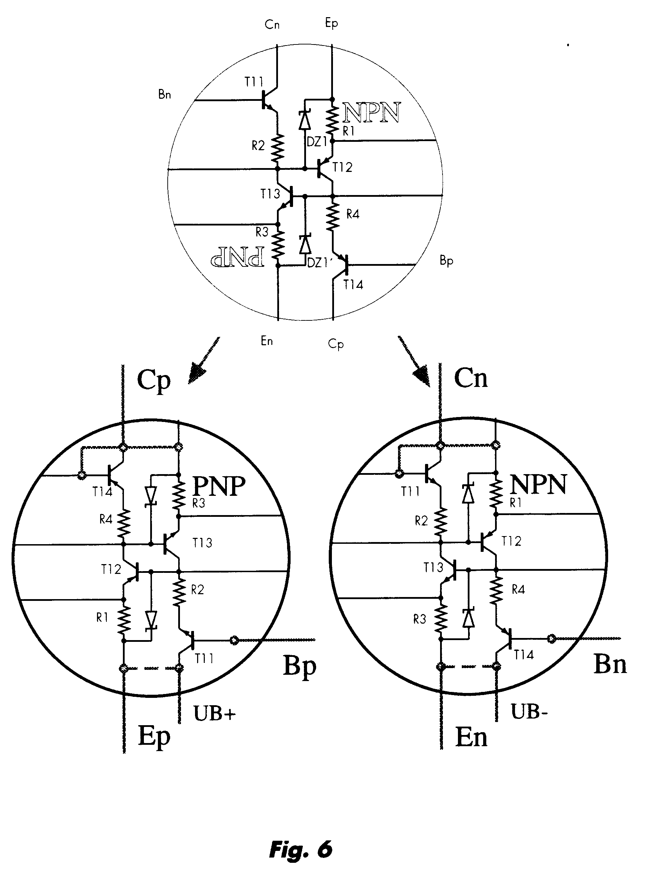

Die erfindungsgemäße Schaltungsanordnung in der strengen vertikalen Symmetrie erschließt universelle Anwendungsmöglichkeiten. Figur 6 zeigt ein unverdrahtetes Bauteil, dessen Schaltungstechnik Figur 3 entspricht.Die Verbindung des Versorgungsspannungsanschlusses Ub des ersten Transistors (T11,T14) mit dem Emitter des zweiten Transistors (T12,T13) spart einen Außenanschluß des Bauteils.

Der Basisanschluß Bp des Transistors T14 kann dabei als Basis einer npn-Transistorstruktur beschaltet werden. Durch Zusammenschaltung des Kollektors Cn und der Basis Bn des Transistors T11 (Cn) mit dem Emitter-Anschluß des Transistors T12 am freien Ende des Widerstands R1 (Ep) und des Kollektors des Transistors T14 (Cp) mit dem Emitter-Anschluß des Transistors T13 jenseits des Widerstandes R3 (En) bilden diese beiden Zusammenschlüsse Emitter und Kollektor des npn-Transistors.

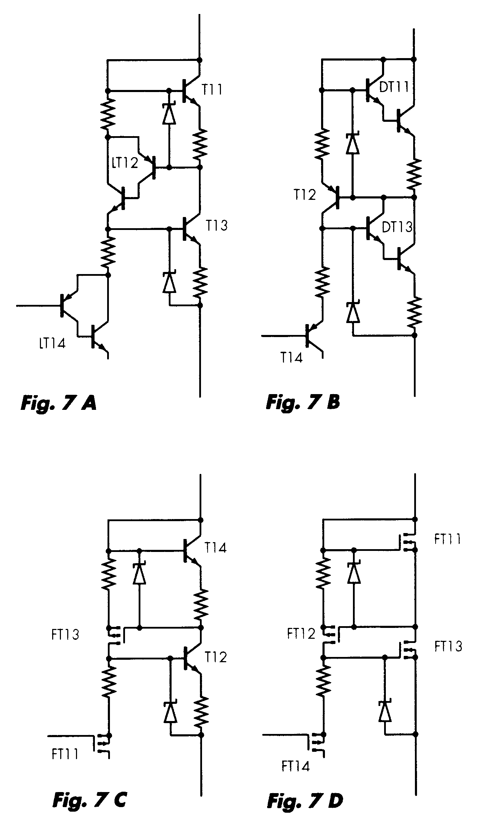

Das Bauteil gemäß Figur 6 kann in ähnlicher Weise als pnp-Transistor verwendet werden, wofür die Basis des Transistors T11 (bn) als Basiseingang verwendet wird.
Die übrigen Anschlüsse der universellen Struktur gemäß der Figur 6 können zu Kompensations- und Trimmzwecken verwendet werden. Die Figuren 7A bis 7D zeigen verschiedene gemischt zusammengesetzte Bauteile mit aufrecht erhaltener vertikaler Symmetrie. Figur 7D zeigt ein entsprechendes Bauteil in MOSFET-Technik mit entsprechenden Feldeffekttransistoren FT11 bis FT14 und zusatzwiderstandslosem Ausgangskreis.Dies ist bei genügend hohem Innenwiderstand der Transistorquelle und hinreichender Kennliniengleichheit beider Transistoren (FT11,FT13) möglich.

Da es unter den vertikalen Symmetriebedingungen ausschließlich auf die Identität der miteinander in Serie geschaltete Verstärkungsbauteile ankommt, ist das universelle Bauteil gemäß Figur 6 auch unkompliziert in einer Hybrid-Technik ausführbar, wobei beispielsweise zwei Feldeffektttransistoren FT11 und FT13 mit zwei bipolaren Transistoren T12 und T14 zu einem Bauteil kombiniert werden.

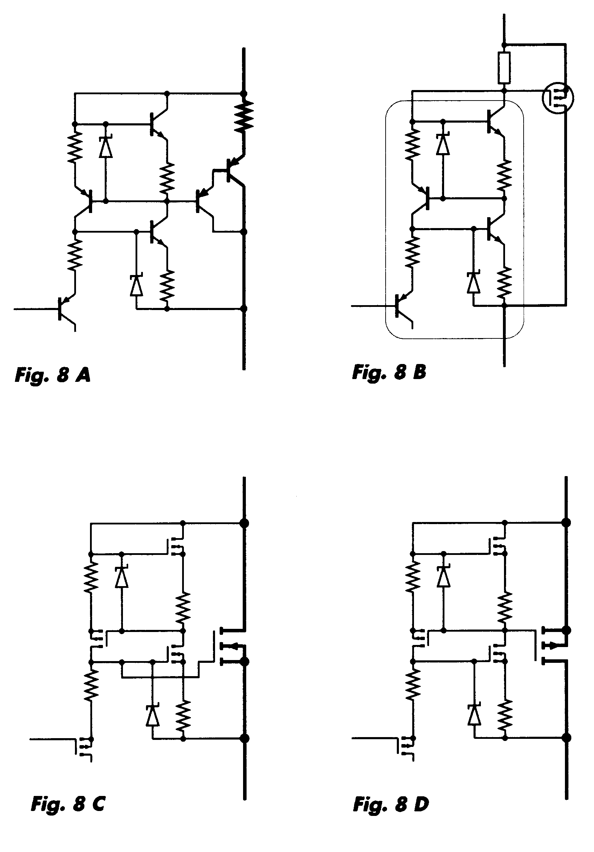

Die Figuren 8A bis 8D zeigen unterschiedliche Leistungstransistoranwendungen,wobei der universale Schaltkreis sowohl als Steuerstufe für eine an sich unlinear arbeitende Leistungsstromquelle dient, als auch zur Steuerspannungsvorentzerrung für einen Leistungsemitter- oder Sourcefolger.

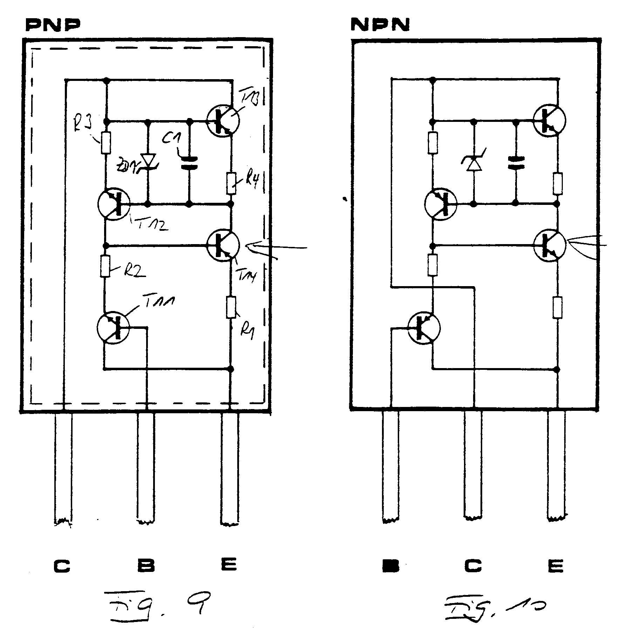

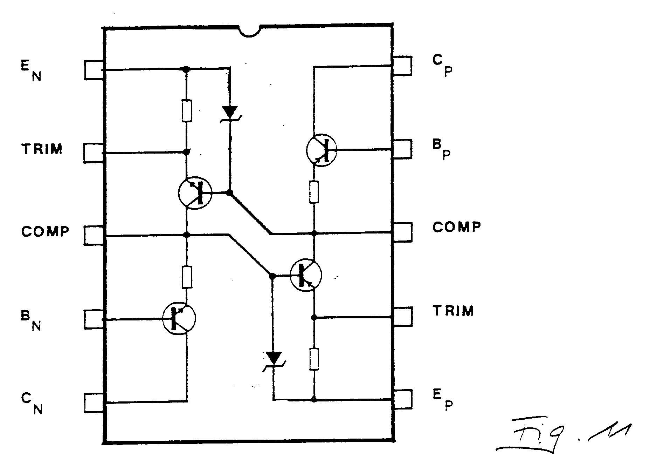

In den Figuren 9 und 10 sind zwei spezielle Transistorschaltungen in pnp-und npn-Technik gezeigt. Die beiden Schaltungen unterscheiden sich lediglich durch die komplentäre Ausbildung der Transistoren T11 bis T14. Sie bilden synthetisch lineare Transistor-Ersatzstrukturen.

Figur 11 zeigt die in Figur 6 dargestellte universelle Struktur in einer Ausbildung einer integrierten Schaltung mit symmetrisch angeordneten Zehnerdioden ZD1 und ZD3 als Schutzdioden.

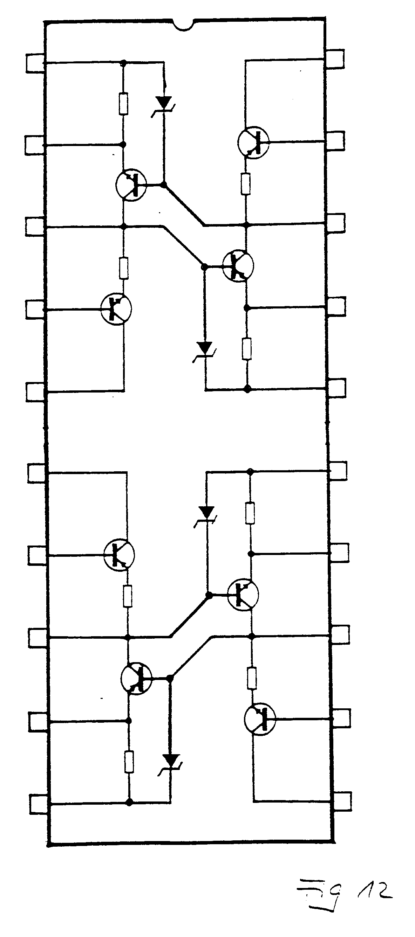

Die komplementär verdoppelte Ausbildung des Schaltkreises gemäß Figur 11 führt zu dem in Figur 12 dargestellten Schaltkreis, der nicht vorverdrahtet ist und somit über zwanzig Anschlüsse verfügt. Durch eine interne Vorverdrahtung kann die Zahl der Anschlüsse naturgemäß ohne Schwierigkeiten verringert werden.

Es ist erkennbar, daß die in den Figuren 6 bis 12 dargestellten Strukuren universell verwendbar sind und lediglich in Abhängigkeit von der externen Beschaltung vielfältige Einsatzmöglichkeiten erschließen. Insbesondere lassen sich ideale, also ausgangsspannungsverlustfreie Transistoren realisieren, die bei Einhalten der vertikalen Symmetrie gemäß den Figuren 3 und 4 vollständig kennlinien- und temperaturkompensiert sind. Die Anwendungsmöglichkeiten derartiger Bauelemente und ihre Vorteile erschließen sich ohne weitere Erläuterung.

Es ist ohne weiteres möglich, die Transistoren gemäß den Figuren 9 und 10 gleich als Leistungsstransistoren auszubilden, in dem die Transistoren T13 und T14 in einer Darlington-Schaltung ausgebildet und somit für Leistungszwecke geeignet sind. Selbstverständlich ist es dabei auch möglich, die Transistoren T11 und T12 als Darlington-Schaltungen auszubilden, um somit eine vollständige Darlington-Struktur zu erzugen, die zu einer internen Basisstromerniedrigung führt.

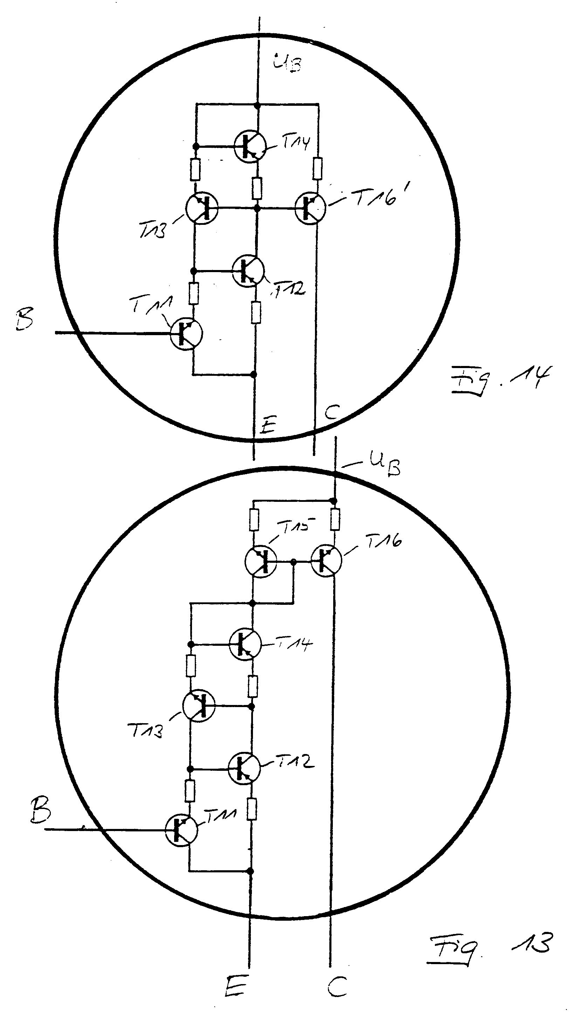

Figur 13 zeigt eine synthetische Transistor-Ersatzstruktur, die mit einer Wandlerschaltung, wie sie prinzipiell in Figur 3 dargestellt ist, aufgebaut ist. Diese bildet an der Basis des Transistors T11 einen Basisanschluß B und an dessen Kollektor einen Emitter-Anschluß E. Ein Kollektoranschluß C ist über einen weiteren Stromspiegel T15, T16 von der Wandlerschaltung entkoppelt. Dem Stromspiegel wird eine Versorgungsspannung UB über einen gesonderten Anschluß zugeführt. die sich hieraus ergebende Transistorstruktur mit den Anschlüssen B, E und C erlaubt die gleiche Einstellung der Ruhe-Spannungspotentiale an allen drei Anschlüssen B, E und C.

Figur 14 zeigt ebenfalls eine Transistor-Ersatzstruktur mit den Anschlüssen B, E, und C wobei die Stromentlastung mit einem Transistor T16'vorgenommen wird, der zusammen mit dem Transistor T14 einen Stromspiegel bildet. Der Transistor T14 wird also für zwei Stromspiegel T13, T14 und T14, T16' doppelt ausgenutzt. Über die Kollektor-Basis-Kapazität des Transistors T16' findet eine kapazitive Kollektor-Rückwirkung zur Wandlerschaltung statt.

Die in den Figuren 13 und 14 dargestellten Bauteile erlauben eine Spannungsverstärkung, bei der die verstärkte Spannung an gleichen Potentialen abnehmbar ist wie die Eingangspotentiale, so daß mehrere Stufen ohne weiteres hintereinander schaltbar sind.

**Patentansprüche**

1. Wandlerschaltung bestehend aus einem ersten Transistor (T1, T1'; T11, T11'; FT11) dessen Basis ein Eingangssignal zuführbar ist, einem zweiten, zum ersten Transistor (T1, T1'; T11, T11'; FT11) komplementären Transistor (T2, T12'; T12, T12'; FT12) dessen Basis mit dem Emitter des ersten Transistors (T1, T1'; T11, T11'; FT11) verbunden ist und dessen Emitter über einen ersten Widerstand (R1) mit einer Ausgangsklemme (B) verbunden ist und mit einer Stromzuführungsschaltung (T3, T4; T3', T4'; T13, T14; T13', T14'; FT13, FT14) die den Stromfluß durch die Emitter-Kollektor-Strecken der beiden Transistoren (T1, T1'; T11, T11'; FT11; T2, T2'; T12, T12'; FT12) steuert, gekennzeichnet durch einen mit dem Emitter des ersten Transistors (T1, T1'; T11, T11'; FT11) verbundenen zweiten Widerstand (R2, R2'), der vom Kollektor-Emitter-Strom des ersten Transistors (T1, T1'; T11, T11'; FT11) durchflossen ist und über den der Emitter des ersten Transistors (T1, T1'; T11, T11'; FT11) mit der Basis des zweiten Transistors (T2, T2'; T12, T12'; FT12) verbunden ist.

2. Wandlerschaltung nach Anspruch 1, dadurch gekennzeichnet,daß der zweite Widerstand ( R2,R2')und der erste Widerstand (R1,R1')-jeweils durch einen komplementären, als Diode geschalteten Transistor (T5,T6;T5',T6') in Serie ergänzt sind.

3. Wandlerschaltung nach Anspruch 1 und 2, dadurch gekennzeichnet, daß die Stromzuführungsschaltung einen Stromspiegel mit zwei mit ihren Basen miteinander verbundenen Transistoren (T3, T4; T3', T4'; T13, T14; T13', T14'; FT13, FT14) beinhaltet.

4. Wandlerschaltung nach Anspruch 1 bis 3, dadurch gekennzeichnet, daß die Transistoren des Stromspiegels die gleiche Polarität aufweisen, wie der ihm jeweils zugeordnete, vom gleichen Strom durchflossene erste bzw. zweite Transistor (T1, T1'; T11, T11'; FT11; T2, T2'; T12, T12'; FT12).

5. Wandlerschaltung nach Anspruch 1 bis 4, dadurch gekennzeichnet, daß die beiden jeweils vom gleichen Strom durchflossenen Transistoren als gleiche Doppeltransistoren auf einem gemeinsamen Substrat ausgebildet sind.

6. Wandlerschaltung nach Anspruch 5, dadurch gekennzeichnet, daß alle,zueinander symmetriesch ausgerichtete Transistoren und deren Widesstände auf einem gemeinsamen Substat ausgebildet sind.

7. Wandlerschaltung nach einem der Ansprüche 1 bis 6, dadurch gekennzeichnet, daß der zweite Widerstand (R2, R2') relativ zum ersten Widerstand (R1, R1') dimensioniert ist und bei R 1 > R 2 eine positiven Ausgangswiderstand, Bei R 1< R 2 einen negativen Ausgangswiderstand und bei R 1 = R 2 eine Ausgangswiderstand von Null hervorruft.

8. Wandlerschaltung nach einem der Ansprüche 1 bis7, dadurch gekennzeichnet, daß die Widerstände des Stromspiegels (R3,R4;R3',R4') relativ zueinander dimensioniert sind und den Ausgangswiderstand festlegen.

9. Wandlerschaltung nach einem der Ansprüche 1 bis 8, dadurch gekennzeichnet, daß die vertikal vom selben Strom durchflossenen Widerstände (R1,R4;R2,R3) relativ zueinander dimensioniert sind und den Ausgangswiderstand festlegen.

10. Wandlerschaltung nach einem der Ansprüche 1 bis 9, dadurch gekennzeichnet, daß die axial symmetrischen Widerstände unlineare spannungsabhängige Widerstände mit gleichen Kennlinien sind.

11. Wandlerschaltung nach einem der Ansprüche 1 bis 10, dadurch gekennzeichnet, daß die Widerstände einer Symmetrieache überbrückt sind.

12. Wandlerschaltung nach einem der Ansprüche 1 und 4 bis 11, dadurch gekennzeichnet, daß der erste Transistor zusammen mit dem zweiten Widerstand und einem zugehörigen Transistor des Stromspiegels eine Konfiguration mit zwei gleichpoligen Transistoren und einem zwischengeschalteten Widerstand bildet, die invers am zweiten Transistor zusammen mit einem zwischengeschalteten Widerstand und einem zugehörigen Transistors des Stromspiegels realisiert ist.

13. Wandlerschaltung nach Anspruch 12, dadurch gekennzeichnet, daß in jedem Brückenzweig jeweils ein Widerstand hinzugeschaltet ist, dessen Wert den ersten Widerstand (R 1, R 1') entspricht.

14. Wandlerschaltung nach einem der Ansprüche 1 bis 13, dadurch gekennzeichnet, daß sie als komplementäre Wandlerschaltung ausgebidlet ist.

15. Wandlerschaltung nach Anspruch 5 bis 14, dadurch gekennzeichnet, daß vier gleiche Konfigurationen zu einer Brücke zusammengeschaltet sind, wobei jeweils zwei zueinander inverse Konfigurationen hintereinandergeschalteteBrückenzweige bilden.

16. Wandlerschaltung nach einem der Ansprüche 1 bis 15, gekennzeichnet durch eine Vorspannungsquelle zur Verlustleistungsbegrenzung (ZD1,ZD1'), die zwischen Basis und Emitterwiderstand der Transistoren (T2, T2'; T12, T12'; FT12) geschaltet ist.

17. Wandlerschaltung nach Anspruch 14, dadurch gekennzeichnet, daß die Vorspannungsquelle zur Ruhestromeinstellung (ZD2) zwischen den Basen der zueinander inversen zweiten Transistoren (T2, T2'; T12, T12'; FT12) angeordnet ist.

18. Wandlerschaltung nach Anspruch 14 und 17, dadurch gekennzeichnet, daß die Vorspannungsquelle zur Ruhestromeinstellung ein linarer Widerstand im begrenzenden Ruhestromnebenpfad ist.

19. Wandlerschaltung nach Anspruch 14 und 17, dadurch gekennzeichnet, daß die Vorspannungsquelle zur Ruhestromeinstellung ein spannungsabhängiger Widerstand im begrenzenden Ruhestromnebenpfad ist.

20. Wandlerschaltung nach Anspruch 14 und 17, dadurch gekennzeichnet, daß eine aktive Vorspannungsquelle einen Ruhestromgegenkoppelungspfad bildet.

21. Wandlerschaltung nach Anspruch 14 und 17 und 19 bis 20, dadurch gekennzeichnet, daß die Vorspannungsquelle unmittelbar mit der Schaltung thermisch gekoppelt ist.

22. Wandlerschaltung nach Anspruch 14 und 17 bis 21, dadurch gekennzeichnet, daß der Ruhestrom durch eine Stromquelle in einem Stromnebenpfad der Schaltung initiertt wird.

23. Wandlerschaltung nach Anspruch 14 und 17 bis 21, dadurch gekennzeichnet, daß der Ruhestrom durch Zusatzeinspeisung zweier,gleich dimensionierter Stromquellen von beiden Versorgungsspannungsseiten initiert wird.

24. Wandlerschaltung nach Anspruch 14 und 17 bis 23, dadurch gekennzeichnet, daß der Ruhestrom über veränderbare Stromquellen festgelegt wird.

25. Wandlerschaltung nach einem der Ansprüche 1 bis 24, dadurch gekennzeichnet, daß die Versorgungsspannung (UB) über eine Stromentlastungsschaltung (T15, T16; T13, T16') zuführbar ist.

26. Wandlerschaltung nach Anspruch 25, dadurch gekennzeichnet, daß die Stromentlastungsschaltung durch einen Stromspiegel gebildet ist.

27. Wandlerschaltung nach einem der Ansprüche 1 bis 26, dadurch gekennzeichnet, daß sie je eine synthetisch-lineare-Transistor-Ersatzstruktur mit Transistoranschlüssen (B, E, C,Ub) bildet.

28. Wandlerschaltung nach Anspruch 27, dadurch gekennzeichnet, daß die Transistoranschüsse Ub und E verbunden sind .

29. Wandlerschaltung nach Anspruch 25 oder 26 und 27, dadurch gekennzeichnet, daß der Kollektoranschluß (C) der Transistorersatzstruktur über die Stromentlastungsschaltung (T15, T16; T13, T16') spannungsmäßig entkoppelt ist.

30. Wandlerschaltung nach den Ansprüchen 1 bis 29,dadurch gekennzeichnet, daß die beschriebene Transistorstruktur eine universelle Transistorersatzstruktur mit der Bezeichnung 'Synthetisch Linearer Transistor', kurz 'SLT' bildet.

Fig. 1

Fig. 2 A

Fig. 2 B

10

**Fig. 3**

**Fig. 4**

**Fig. 5 B**

**Fig. 5 A**

**Fig. 5 C**

13

**Fig. 5 D**

**Fig. 6**

T11

LT12

T13

LT14

**Fig. 7 A**

DT11

T12

DT13

T14

**Fig. 7 B**

T14

FT13

T12

FT11

**Fig. 7 C**

FT11

FT12

FT13

FT14

**Fig. 7 D**

**Fig. 8 A**

**Fig. 8 B**

**Fig. 8 C**

**Fig. 8 D**

PNP

NPN

C     B     E

    B     C     E

Fig. 9

Fig. 10

*Fig. 11*

Fig 12

Fig. 14

Fig. 13

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,Y | DE-A-3 035 471 (PIONEER ELECTRONIC CORP.) <br> * das ganze Dokument * <br> --- | 1,3,14 | H03F3/50 <br> H03F3/30 |
| Y | NEW ELECTRONICS.INCORPORATING ELECTRONICS TODAY. Bd. 19, Nr. 22, November 1986, LONDON GB Seite 18; <br> L. SAGE: 'HIGH PERFORMANCE BUFFER' <br> * das ganze Dokument * <br> --- | 1,3,14 | |
| A | US-A-4 771 227 (C.T. NELSON) <br> * Spalte 2, Zeile 23 - Spalte 4, Zeile 38; Abbildungen 1,2 * <br> --- | 1,3-10 | |
| A | EP-A-0 394 807 (SGS-THOMSON) <br> * Seite 3, Zeile 13 - Seite 4, Zeile 31; Abbildung 4 * <br> --- | 4-6,12 | |
| A | EP-A-0 209 987 (COMLINEAR CORPORATION) <br><br> * Seite 4, Zeile 24 - Seite 7, Zeile 20; Abbildung 4 * <br> --- | 1,2,14, 22,23 | |
| A | GB-A-1 059 112 (THE BRITISH BROADCASTING CORPORATION) <br> * Seite 2, Zeile 90 - Seite 3, Zeile 31; Abbildung 2 * <br><br> ----- | 16-19 | **RECHERCHIERTE SACHGEBIETE (Int. Cl.5)** <br><br> H03F |

Der vorliegende Recherchenbericht wurde für alle Patentansprüche erstellt

| Recherchenort | Abschlußdatum der Recherche | Prüfer |
|---|---|---|
| DEN HAAG | 09 JUNI 1992 | TYBERGHIEN G.M. |